# EUROPÄISCHE PATENTANMELDUNG

(11) **EP 4 507 461 A1**
(43) Veröffentlichungstag der Anmeldung: **12.02.2025**
(21) Anmeldenummer: 24191636.0
(22) Anmeldetag: 30.07.2024
(51) Int. Cl.: H05K 5/02, H05K 5/00

(54) **ELEKTRONIKMODUL FÜR EIN HAUSHALTSGERÄT UND VERFAHREN ZUR HERSTELLUNG EINES ELEKTRONIKMODULS FÜR EIN HAUSHALTSGERÄT**

(30) Priorität: 09.08.2023 BE 202305671
(71) Anmelder: Miele & Cie. KG, 33332 Gütersloh (DE)
(72) Erfinder: Robbert, Andreas, 59469 Ense-Lüttringen (DE); Friedrich, Robin, 59823 Arnsberg (DE)

(57) **Zusammenfassung**

Die Erfindung betrifft ein Elektronikmodul (110) für ein Haushaltsgerät (100), wobei das Elektronikmodul (110) einen Modulträger (120), der ein elektronisches Bauelement (130) aufweist, das mittels einer Leitung (135) kontaktierbar und/oder kontaktiert ist und eine Abdeckeinheit (140) umfasst, die auf dem Modulträger (120) befestigt ist, wobei die Abdeckeinheit (140) das elektronische Bauelement (130) zumindest teilweise abdeckt und die Leitung (135) zugentlastet und/oder einklemmt.

## Beschreibung

Die Erfindung betrifft ein Elektronikmodul für ein Haushaltsgerät und ein Verfahren zur Herstellung eines Elektronikmoduls für ein Haushaltsgerät gemäß den Hauptansprüchen.

In Haushaltsgeräten werden oftmals Elektronikmodule verwendet, die entsprechend über eine Leitung oder ein Kabel elektrische Bauelemente mit Energie versorgen und/oder deren Signale über eine solche Leitung oder ein Kabel weiterleiten. Dabei wird oftmals das Kabel oder die Leitung im Haushaltsgerät in einer bestimmten Position geführt, sodass vor einer Anbindung dieser Leitung an das elektronische Bauelement eine Zugentlastung erfolgen sollte, um einen dauerhaften sicheren Sitz dieser Leitung am elektronischen Bauelement zu gewährleisten. Jedoch erfordern derartige Lösungen für eine solche Zugentlastung einen hohen Material- und Montageaufwand und bestehende Zugentlastungen beeinflussen die Optik des Geräts im Anschlussbereich durch Farbe und Geometrie meist negativ. Ferner müssen handelsübliche Zugentlastungen meist durch spezielles Werkzeug montiert werden.

Der hier vorgestellte Ansatz stellt sich die Aufgabe, ein verbessertes Elektronikmodul zu und ein verbessertes Verfahren zur Herstellung eines Elektronikmoduls für ein Haushaltsgerät schaffen.

Erfindungsgemäß wird diese Aufgabe durch ein Elektronikmodul und ein Verfahren zur Herstellung eines Elektronikmoduls für ein Haushaltsgerät mit den Merkmalen bzw. den Schritten der Hauptansprüchen gelöst. Vorteilhafte Ausgestaltungen und Weiterbildungen der Erfindung ergeben sich aus den nachfolgenden Unteransprüchen.

Der vorgeschlagene Ansatz schafft ein Elektronikmodul für ein Haushaltsgerät, wobei das Elektronikmodul folgende Merkmale aufweist:
- einem Modulträger, der ein elektronisches Bauelement aufweist, das mittels einer Leitung kontaktierbar und/oder kontaktiert ist; und
- eine Abdeckeinheit, die auf dem Modulträger befestigt ist, wobei die Abdeckeinheit das elektronische Bauelement zumindest teilweise und/oder vollständig abdeckt und die Leitung zugentlastet und/oder einklemmt.

Unter einem Elektronikmodul kann vorliegend ein elektronisches oder elektrisches Bauteil verstanden werden, welches in der Lage ist, gewisse Funktionalitäten zu erfüllen. Hierzu kann beispielsweise ein elektronisches Bauelement vorgesehen sein, das als Schalter, Eingabeelement, Aktor und/oder Recheneinheit zur Ausführung der gewünschten Funktionalität ausgestaltet ist und dass einerseits auf einem Modulträger angeordnet oder befestigt ist und mittels einer Leitung von außerhalb dieses elektronischen Bauelement kontaktierbar und/oder kontaktiert ist. Eine solche Kontaktierung kann beispielsweise die Zuführung oder Abführung von elektrischer Energie zu dem elektronischen Bauelement und/oder die Zuführung und/oder Abführung von Signalen von diesem elektronischen Bauelement ermöglichen. Unter einer Abdeckeinheit kann vorliegend ein Element oder eine Komponente verstanden werden, welches bzw. welche ausgebildet ist, um das elektronische Bauelement zumindest teilweise und/oder vollständig abzudecken und somit gegen Umwelteinflüsse zu schützen. Zugleich kann diese Abdeckeinheit als Komponente verwendet werden, welches eine Zugentlastung der Leitung ermöglicht.

Der vorgeschlagene Ansatz basiert auf der Erkenntnis, dass durch die Verwendung der Abdeckeinheit für die Funktion der Abdeckung des elektronischen Bauelements als auch der Zugentlastung ein geringer Materialeinsatz und eine Bauraum-sparende Lösung vorgesehen werden kann, um die vorstehend genannten Ziele erreichen zu können. Zugleich lässt sich eine solche Abdeckeinheit mit einem geringen Montageaufwand auf dem Modulträger befestigen.

Besonders wichtig ist eine Ausführungsform des hier vorgeschlagenen Ansatzes, bei der die Abdeckeinheit zweiteilig ausgestaltet ist und wobei die Leitung zwischen den zwei Teilen der Abdeckeinheit eingeklemmt ist. Beispielsweise können diese beiden Teile der Abdeckeinheit in großer Stückzahl und somit einfach hergestellt und technisch ohne großen Aufwand montiert werden, sodass eine solche Ausführungsform kostengünstig realisiert werden kann.

Hierbei können gemäß einer weiteren Ausführungsform die zwei Teile der Abdeckeinheit identisch ausgeformt sein. Beispielsweise können diese beiden Teile der Abdeckeinheit unsymmetrisch bzw. spiegelverkehrt ausgestaltet sein, sodass ein Zusammenstecken dieser beiden Teile eine Montage der Abdeckeinheit sehr einfach ausführen lässt.

Gemäß einer weiteren Ausführungsform des hier vorgeschlagenen Ansatzes kann die Abdeckeinheit die Leitung mittig zugentlasten und/oder einklemmen. Eine solche Ausführungsform bietet den Vorteil, speziell beim Zusammenstecken von zwei Teilen der Abdeckeinheit eine Zugentlastung der Leitung schnell und einfach montierbar zu realisieren.

Besonders günstig ist eine Ausführungsform des hier vorgeschlagenen Ansatzes, bei der die Abdeckeinheit ausgebildet ist, um das elektronische Bauelement vor Wrasen zu schützen. Eine solche Ausführungsform bietet speziell im Bereich für den Kücheneinsatz des Haushaltsgeräts den Vorteil, eine Störung der Funktion des elektronischen Bauelement durch Kochdämpfe zu verhindern oder zumindest zu reduzieren.

Sehr schnell, sicher und ohne großen Montageaufwand lässt sich eine Ausführungsform des hier vorgeschlagenen Ansatzes montieren, bei der die Abdeckeinheit zumindest eine Haltenase aufweist, die in eine Aussparung des Modulträgers eingerastet ist.

Besonders sicher und stabil lässt sich eine Ausführungsform des hier vorgeschlagenen Ansatzes realisieren, bei der die zumindest eine Haltenase einen Rasthaken aufweist, um in der Aussparung einzurasten.

Auch kann gemäß einer weiteren Ausführungsform die Abdeckeinheit auf den Modulträger geklebt sein. Eine solche Ausführungsform bietet den Vorteil einer sehr stabilen und sicheren Zugentlastung für die Leitung.

Sehr kostengünstig herstellbar ist eine Ausführungsform des hier vorgeschlagenen Ansatzes, bei der die Abdeckeinheit zumindest teilweise als Kunststoff-Element ausgebildet ist.

Gemäß einer anderen Ausführungsform des hier vorgeschlagenen Ansatzes kann die Abdeckeinheit als Wanne oder Deckel-förmiges Element ausgebildet sein. Eine solche Ausführungsform bietet den Vorteil, neben der gewünschten Zugentlastung noch einen möglichst umfänglichen Schutz des elektronischen Bauelements gegenüber Umwelteinflüssen zu bieten.

Eine besonders große Zuverlässigkeit zur Realisierung von gewünschten Funktionen bietet eine Ausführungsform des hier vorgeschlagenen Ansatzes, bei dem das elektronische Bauelement als Bedienteil und/oder als Anzeigeeinheit für ein Haushaltsgerät, vorzugsweise eine Dunstabzugshaube, ausgestaltet ist.

Sehr stabil und robust ist eine Ausführungsform des hier vorgeschlagenen Ansatzes, bei der der Modulträger als Metallteil, insbesondere als Blech ausgestaltet ist.

Die hier vorgeschlagenen Vorteile lassen sich insbesondere in einer Ausführungsform besonders günstig realisieren, bei der ein Haushaltsgerät ein Elektronikmodul gemäß einer hier vorgestellten Variante aufweist. Durch einen Schutz des Elektronikmoduls über die erfindungsgemäße Abdeckeinheit kann das Haushaltsgerät beispielsweise vorteilhaft eine Dunstabzugseinheit, wie etwa eine Dunstabzugshaube sein.

Auch wenn der beschriebene Ansatz anhand eines Haushaltgeräts beschrieben wird, kann der hier beschriebene Ansatz entsprechend im Zusammenhang mit einem gewerblichen oder professionellen Gerät, beispielsweise einem Großküchengerät, einem medizinischen Gerät, wie einem Reinigungs- oder Desinfektionsgerät, einem Kleinsterilisator, einem Großraumdesinfektor oder einer Container-Waschanlage eingesetzt werden.

Ferner schafft der hier vorgestellte Ansatz ein Verfahren zur Herstellung eines Elektronikmoduls für ein Haushaltsgerät, wobei das Verfahren folgende Schritte aufweist:
- Bereitstellen eines Modulträgers, der ein elektronisches Bauelement aufweist, das mittels einer Leitung kontaktiert ist und einer Abdeckeinheit; und
- Befestigen der Abdeckeinheit auf dem Modulträger, sodass die Abdeckeinheit das elektronische Bauelement zumindest teilweise und/oder vollständig abdeckt und die Leitung zugentlastet und/oder einklemmt.

Der hier vorgestellte Ansatz schafft ferner eine Steuereinheit, die ausgebildet ist, um die Schritte einer Variante eines hier vorgestellten Verfahrens in entsprechenden Einrichtungen durchzuführen, anzusteuern bzw. umzusetzen. Auch durch diese Ausführungsvariante der Erfindung in Form einer Vorrichtung kann die der Erfindung zugrunde liegende Aufgabe schnell und effizient gelöst werden.

Die Steuereinheit kann ausgebildet sein, um Eingangssignale einzulesen und unter Verwendung der Eingangssignale Ausgangssignale zu bestimmen und bereitzustellen. Ein Eingangssignal kann beispielsweise ein über eine Eingangsschnittstelle der Steuereinheit einlesbares Sensorsignal darstellen. Ein Ausgangssignal kann ein Steuersignal oder ein Datensignal darstellen, das an einer Ausgangsschnittstelle der Steuereinheit bereitgestellt werden kann. Die Steuereinheit kann ausgebildet sein, um die Ausgangssignale unter Verwendung einer in Hardware oder Software umgesetzten Verarbeitungsvorschrift zu bestimmen. Beispielsweise kann die Steuereinheit dazu eine Logikschaltung, einen integrierten Schaltkreis oder ein Softwaremodul umfassen und beispielsweise als ein diskretes Bauelement realisiert sein oder von einem diskreten Bauelement umfasst sein.

Von Vorteil ist auch ein Computer-Programmprodukt oder Computerprogramm mit Programmcode, der auf einem maschinenlesbaren Träger oder Speichermedium wie einem Halbleiterspeicher, einem Festplattenspeicher oder einem optischen Speicher gespeichert sein kann. Wird das Programmprodukt oder Programm auf einem Computer oder einer Steuereinheit ausgeführt, so kann das Programmprodukt oder Programm zur Durchführung, Umsetzung und/oder Ansteuerung der Schritte des Verfahrens nach einer der hier beschriebenen Ausführungsformen verwendet werden.

Ein Ausführungsbeispiel der Erfindung ist in den Zeichnungen rein schematisch dargestellt und wird nachfolgend näher beschrieben. Es zeigt
- Figur 1: eine perspektivische Explosionsdarstellung eines Teils eines Ausführungsbeispiels eines Haushaltsgeräts, das ein Elektronikmodul gemäß einem Ausführungsbeispiel des hier vorgestellten Ansatzes aufweist;
- Figur 2: eine perspektivische Darstellung eines nach dem hier vorgestellten Ansatz hergestellten Elektronikmoduls; und
- Figur 3: ein Ablaufdiagramm eines Ausführungsbeispiels eines Verfahrens zur Herstellung eines Elektronikmoduls für ein Haushaltsgerät.

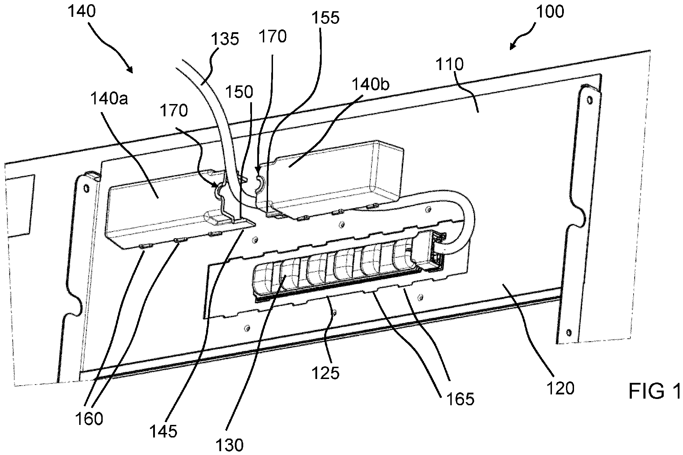

Figur 1 zeigt eine perspektivische Explosionsdarstellung eines Ausführungsbeispiels eines Teils eines Haushaltsgeräts 100, das ein Elektronikmodul 110 gemäß einem Ausführungsbeispiel des hier vorgestellten Ansatzes aufweist. Das Elektronikmodul 110 umfasst einen Modulträger 120, der beispielsweise als ein Metallteil, speziell als ein Blech, ausgestaltet ist. In dem Modulträger 120 ist beispielsweise ein Ausschnitt 125 bzw. eine Öffnung ausgestaltet, wobei in diesem Ausschnitt 125 bzw. der Öffnung ein elektronisches Bauelement 130 eingesetzt oder angeordnet ist. Das elektronische Bauelement 130 kann beispielsweise als Schalter, Display oder, wie es in der Figur 1 jedoch nicht dargestellt ist, als Rechnereinheit zur Ausführung von Steueroperationen ausgebildet sein und über eine Leitung 135 mit elektrischer Energie versorgt werden. Über diese Leitung 135 können beispielsweise auch zusätzlich oder alternativ Steuersignale zum elektronischen Bauelement 130 geleitet und/oder Eingabesignale vom elektronischen Bauelement 130 weggeleitet werden.

Um nun das elektronische Bauelement 130 vor Umgebungseinflüssen zu schützen und zugleich eine Zugentlastung der Leitung 135 vorzunehmen, wird vorliegend eine Abdeckeinheit 140 vorgesehen, die gemäß diesem Ausführungsbeispiel durch zwei identische Teile 140a und 140b zusammengesetzt werden kann. Hierfür können beispielsweise die beiden Teile 140a und 140b unsymmetrisch aufgebaut sein, wie dies beispielsweise im Teil 140b ersichtlich ist, an dessen unteren Ende ein Vorsprung 145 mit einer Rastnase 150 vorgesehen ist, der in eine entsprechende Ausnehmung 155 im anderen Teil 140a der Abdeckeinheit 140 eingreifen kann. Zugleich sind Stege bzw. Haltenasen 160 vorgesehen, die entsprechende entsprechende Aussparungen 165 des Modulträgers 120 eingreifen können und somit für einen sicheren Sitz der Abdeckeinheit 140 auf dem Modulträger 120 sorgen.

Um nun die Zugentlastung der Leitung 135 sicherzustellen, werden die beiden Teile 140a und 140b zusammengefügt, sodass die Leitung 135 zwischen den kreisförmigen Aussparungen 170 der Teile 140a und 140b eingeklemmt wird, wonach die derart zusammengefügten Teile 140a und 140b als Abdeckeinheit 140 auf den Modulträger 120 gepresst werden, sodass die Haltenasen 160 in die entsprechenden Ausnehmungen 165 gedrückt werden und beispielsweise einrasten. Zu einer sicheren Befestigung kann auch die derart gefügte Abdeckeinheit 140 noch mittels Klebstoffs auf dem Modulträger 120 befestigt werden.

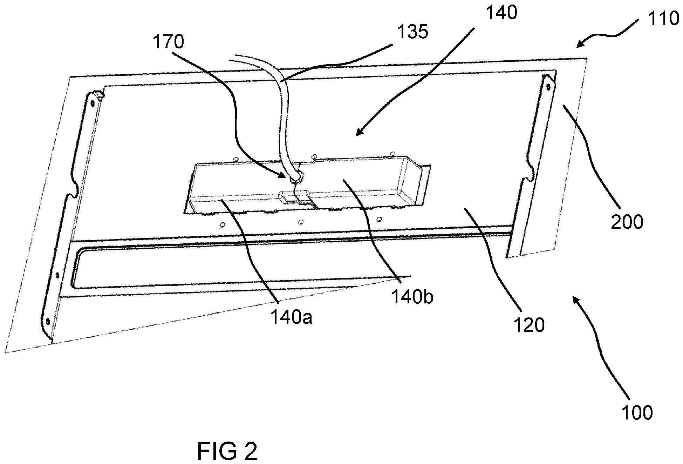

Figur 2 zeigt eine perspektivische Darstellung eines nach dieser Weise hergestellten Ausführungsbeispiel des Elektronikmoduls 110, wobei dieses Elektronikmodul 100 nun beispielsweise rückseitig auf eine Glasscheibe 200 aufgebracht werden kann, beispielsweise wenn das durch die Abdeckeinheit 140 geschützte elektronische Bauelement als ein Display zur Anzeige von Informationen des Haushaltsgerätes 100 durch die Glasscheibe 200 vorgesehen ist.

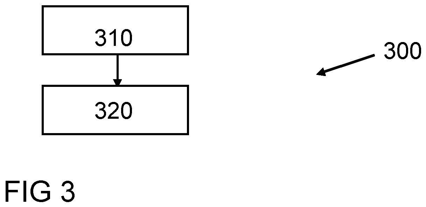

Figur 3 zeigt ein Ablaufdiagramm eines Ausführungsbeispiels eines Verfahrens 300 zur Herstellung eines Elektronikmoduls für ein Haushaltsgerät. Das Verfahren 300 umfasst einen Schritt 310 des Bereitstellens eines Modulträgers, der ein elektronisches Bauelement aufweist, das mittels einer Leitung kontaktiert ist und einer Abdeckeinheit. Ferner umfasst das Verfahren 300 einen Schritt 320 des Befestigens der Abdeckeinheit auf dem Modulträger derart, sodass die Abdeckeinheit das elektronische Bauelement zumindest teilweise und/oder vollständig abdeckt und die Leitung zugentlastet und/oder einklemmt.

Vorteilhaft an der hier vorgestellten Vorgehensweise zur Herstellung des Elektronikmoduls 100 ist, dass das beispielsweise aufgeklebte Bedienteil als elektronisches Bauelement 130 durch die Abdeckeinheit 140 gegen aufsteigenden Wrasen abgeschottet werden kann. Die benötigte Zuleitung bzw. allgemein Leitung 135 kann weiterhin zugentlastet werden, wobei in diesem Fall der zur Verfügung stehende Bauraum sehr gering gehalten werden kann. Es kann somit durch die benötigte Abdeckung gleichzeitig eine Zugentlastung realisiert sein. Hierfür könnten günstigerweise zwei identische Kunststoff-Bauteile ineinander gesteckt und verrasten miteinander werden. Die dadurch erhaltene zweiteilige Abdeckeinheit 140 besitzt an den Flanken zusätzliche Stege/Konturen bzw. Haltenasen 160, die in Ausnehmungen 165 des Modulträgers 120 verrasten können. Durch beispielsweise einen eingebrachten Ausschnitt 125 in dem angrenzenden Blechbauteil als Modulträger 120 werden die beiden Teile 140a bzw. 140b der Abdeckeinheit 140 beim Zusammenrasten in Hinterschnitte bzw. Ausnehmungen 165 eingedrückt. Dadurch entsteht ein Verbund zwischen dem Blechbauteil bzw. Modulträger 120 und der beispielsweise zweiteiligen Abdeckung 140, so dass das dazwischenliegende Bedienteilkabel bzw. die Leitung 135 eingeklemmt und zugentlastet wird.

Der hier vorgestellte Ansatz erweist sich speziell dadurch vorteilhaft, dass keine zusätzlichen Bauteile verwendet werden müssen und keine hohen Werkzeugkosten entstehen. Zugleich ist kein hoher Montageaufwand erforderlich und eine Optik des Gerätes, an dem das Elektronikmodul 100 befestigt wird, wird nicht durch andere Bauteile beeinflusst. Ferner erfordert der hier vorgestellte Ansatz lediglich einen geringen Platzbedarf.

## Patentansprüche

1. Elektronikmodul (110) für ein Haushaltsgerät (100), wobei das Elektronikmodul (110) folgende Merkmale aufweist:
- einen Modulträger (120), der ein elektronisches Bauelement (130) aufweist, das mittels einer Leitung (135) kontaktierbar und/oder kontaktiert ist; und
- eine Abdeckeinheit (140), die auf dem Modulträger (120) befestigt ist, wobei die Abdeckeinheit (140) das elektronische Bauelement (130) zumindest teilweise abdeckt und die Leitung (135) zugentlastet und/oder einklemmt.

2. Elektronikmodul (110) gemäß Anspruch 1, bei dem die Abdeckeinheit (140) zweiteilig ausgestaltet ist und wobei die Leitung (135) zwischen den zwei Teilen (140a, 140b) der Abdeckeinheit (140) eingeklemmt ist.

3. Elektronikmodul (110) gemäß Anspruch 2, wobei die zwei Teile (140a, 140b) der Abdeckeinheit (140) identisch ausgeformt sind.

4. Elektronikmodul (110) gemäß einem der vorangegangenen Ansprüche, bei dem die Abdeckeinheit (140) die Leitung (135) mittig zugentlastet und/oder einklemmt.

5. Elektronikmodul (110) gemäß einem der vorangegangenen Ansprüche, bei dem die Abdeckeinheit (140) ausgebildet ist, um das elektronische Bauelement (130) vor Wrasen zu schützen.

6. Elektronikmodul (110) gemäß einem der vorangegangenen Ansprüche, bei dem die Abdeckeinheit (140) zumindest eine Haltenase (160) aufweist, die in eine Aussparung (165) des Modulträgers (120) eingerastet ist.

7. Elektronikmodul (110) gemäß einem der vorangegangenen Ansprüche, bei dem die Abdeckeinheit (140) auf den Modulträger (120) geklebt ist.

8. Elektronikmodul (110) gemäß einem der vorangegangenen Ansprüche, bei dem die Abdeckeinheit (140) zumindest teilweise als Kunststoff-Element ausgebildet ist.

9. Elektronikmodul (110) gemäß einem der vorangegangenen Ansprüche, bei dem die Abdeckeinheit (140) als Wanne und/oder Deckel-förmiges Element ausgebildet ist.

10. Elektronikmodul (110) gemäß einem der vorangegangenen Ansprüche, bei dem das elektronische Bauelement (130) als Bedienteil und/oder als Anzeigeeinheit für ein Haushaltsgerät (100), insbesondere eine Dunstabzugshaube, ausgestaltet ist.

11. Haushaltsgerät (100) mit einem Elektronikmodul (110) gemäß einem der vorangegangenen Ansprüche.

12. Verfahren (300) zur Herstellung eines Elektronikmoduls (110) für ein Haushaltsgerät (100), wobei das Verfahren (300) folgende Schritte aufweist:
- Bereitstellen (310) eines Modulträgers (120), der ein elektronisches Bauelement (130) aufweist, das mittels einer Leitung (135) kontaktiert und/oder kontaktiert ist und einer Abdeckeinheit (140); und
- Befestigen (320) der Abdeckeinheit (140) auf dem Modulträger (120), sodass die Abdeckeinheit (140) das elektronische Bauelement (130) zumindest teilweise abdeckt und die Leitung (135) zugentlastet und/oder einklemmt.
